# EUROPEAN PATENT APPLICATION

(11) **EP 1 280 269 A1**
(43) Date of publication of application: **29.01.2003**
(21) Application number: 02254846.5
(22) Date of filing: 10.07.2002
(51) Int. Cl.: H03D 7/16

(54) **Television tuner**

(30) Priority: 18.07.2001 GB 0117591
(71) Applicant: Zarlink Semiconductor Limited, Swindon, Wiltshire SN2 2QW (GB)
(72) Inventor: Sawyer, David Albert, Swindon, Wiltshire SN3 1EH (GB)
(74) Representative: Robinson, John Stuart

(57) **Abstract**

A universal highly integrated television tuner is provided for receiving television signals of many different types and standards from terrestrial or cable sources. The input signals are supplied to an RF attenuator (102) forming part of an automatic gain control loop. A tracking low noise amplifier (103) supplies the signals to a tracking filter (104). The filtered signals are supplied to a first frequency changer (105,108,110), which performs up-conversion to a high first intermediate frequency. The resulting signal is filtered before being supplied to a second frequency changer (111-120) performing down-conversion to a conventional second intermediate frequency. The resulting signals are supplied to an automatic gain control detector (122) and to second intermediate frequency filters (124,125). The detector (122) detects the signal level upstream of the single channel filtering (124,125). Both frequency changers comprise image reject mixers (105,116) which receive local oscillator signals from tunable local oscillators (108,114) controlled by hybrid mash fractional N phase locked loop synthesisers (110,111).

## Description

The present invention relates to a television tuner. Such a tuner may be used to receive any type of signal, for example from a terrestrial or satellite antenna or a cable distribution network, and may be arranged to receive signals having analog or digital formats of many different types. Such a tuner is cable of being embodied with a high degree of integration such that most of the circuitry is embodied as a single integrated circuit with very few external components.

Television was first developed for the purpose of transmitting signals representing moving pictures and accompanying soundtracks produced in an analog format generally using amplitude modulation (AM) and frequency modulation (FM) of radio frequency (RF) carriers to transmit different channels, each carrying different program information. The appropriate frequency spectrum was allocated and licensed to broadcasting companies operating in different regions of the world. Typically, three allocated bands evolved across the world, namely VHF1 between 50MHz and 90MHz, VHF3 between 120MHz and 220MHz, and UHF4/5 between 450MHz and 900MHz. The spaces between these bands were licensed for other services. The television broadcast bands were subdivided into separate carrier frequencies separated by the channel bandwidth of each channel. As television developed around the world, different countries and regions adopted similar but unique frequency bands, channel bandwidths and carrier frequency plans within the licensed spectrum bands. Channel bandwidths of 8MHz, 7MHz and 6MHz were adopted in different regions of the world. Initially, signals contained monochrome information but subsequently standards, such as NTSC, SECAM and PAL, were developed to provide transmission of colour television signals.

Television signals were first transmitted from transmitters through the air to local receiving antennae and this is generally referred to as "terrestrial off air transmission". Further development resulted in the transmission of similar forms of signals over cable distribution networks in the spectrum 50MHz to 900MHz. Although similar modulation formats, channel spacing, frequency spectrum and carrier allocation are used in off air transmission and cable distribution, the transmission characteristics of these systems are significantly different. In off air transmission, the received signal strength in different channels can vary significantly according to the distances from different transmitters. The number of received strong signals is usually a small portion of all available channels but the ratio between weak and strong signals can be large, such as 40 to 60 decibels (dBs). The commonest reception problem is attempting to receive sufficient of a wanted signal in the presence of large unwanted signals.

In cable systems, the received signal varies by only a few decibels across all available channels and the received signal strength is often much greater than that which is necessary in order to ensure quasi perfect picture quality. A quasi perfect picture is one that is judged by a viewer to be as good as that from a signal having an infinite signal-to-noise ratio using the same format. For analog format colour television, this occurs at signal levels having a signal-to-noise ratio greater than or equal to about 50dB. Cable reception often presents the problem of coping with much more unwanted signal (in the non-selected channels) distributed evenly across the entire spectrum.

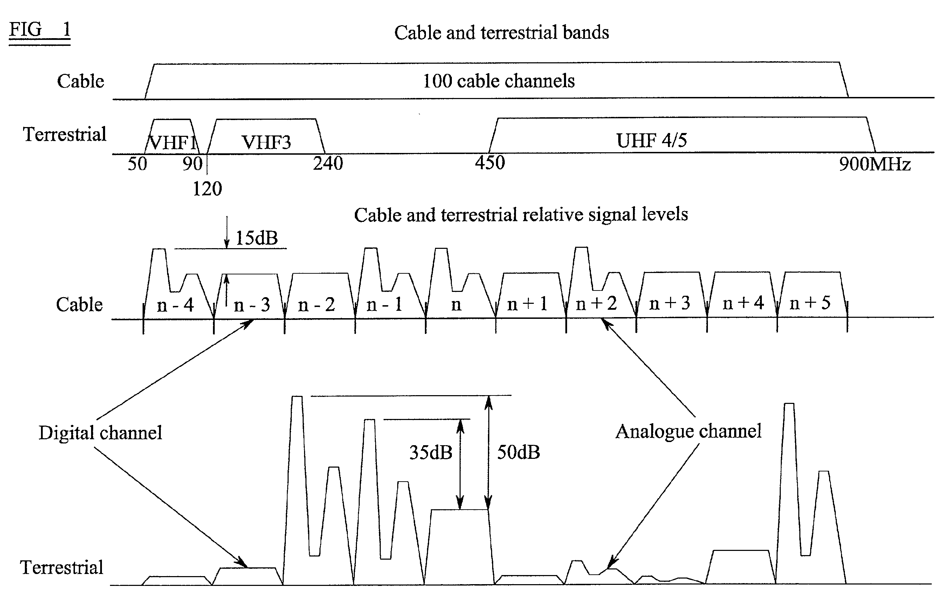

Figure 1 of the accompanying drawings illustrates a typical spectrum allocation for cable and terrestrial television signals together with an indication of the relative levels of cable and terrestrial signals at the input of a television tuner. In particular, this illustrates the relatively constant signal levels of different channels in a cable distribution network as compared with the very large differences in signal levels in different channels received by a terrestrial antenna. In order to cope with the different characteristics of cable and terrestrial signals, two different tuner architectures have largely been adopted with dual conversion architectures being used for cable tuners and single conversion architectures being used for terrestrial tuners.

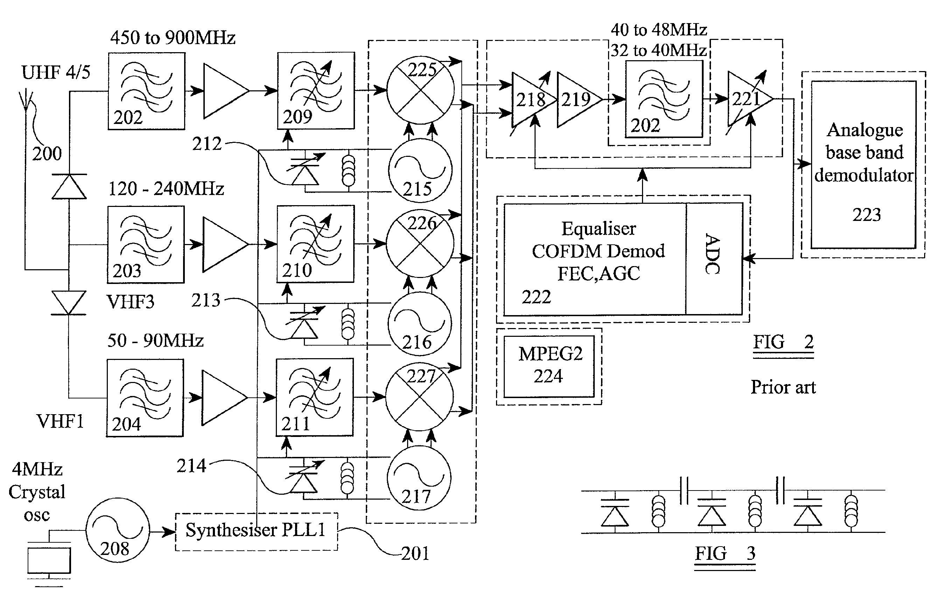

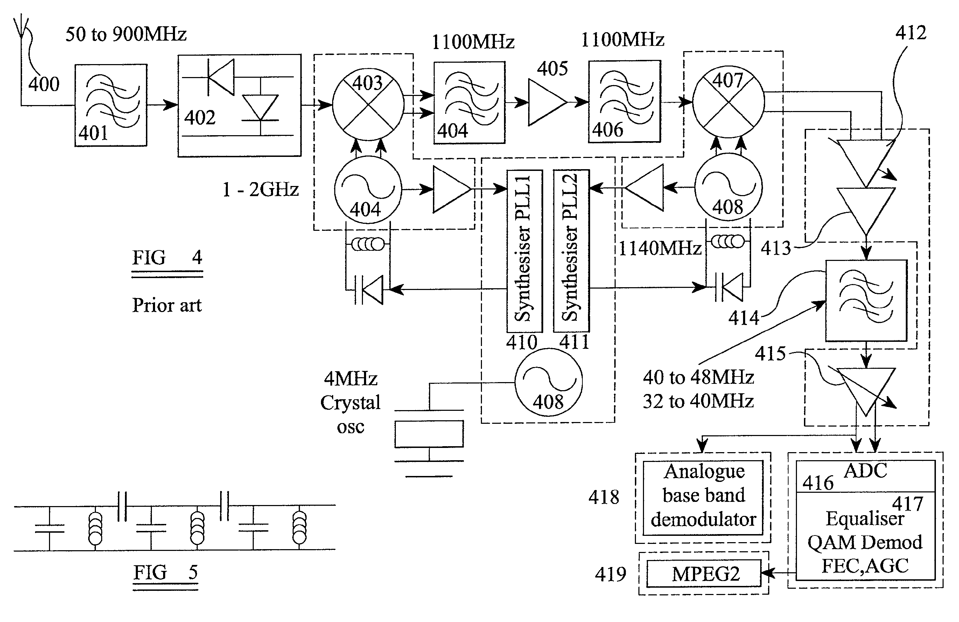

Figure 2 of the accompanying drawings illustrates a typical example of a single conversion terrestrial television tuner architecture of conventional type. Signals from a terrestrial aerial 200 are supplied to the inputs of three fixed band-limiting filters 202, 203 and 204 which pass the different parts of the television spectrum to three "front ends". The UHF 4/5 band from 450 to 900MHz is supplied to a tracking filter 209, for example of the type illustrated in Figure 3 of the accompanying drawings. The output of the filter 209 is supplied to a mixer 225 which also receives a signal from a local oscillator 215. The oscillator 215 has a variable capacitance diode 212 controlled by a phase locked loop synthesiser 201 provided with a crystal-controlled reference oscillator 208. The VHF3 and VHF1 bands are supplied via tracking bandpass filters 210 and 211, respectively, to mixers 220 and 227, respectively, having local oscillators 216 and 217, respectively, provided with variable capacitance diodes 213 and 214, respectively, and controlled by the synthesiser 201.

The tracking filters 209, 210 and 211 are of relatively high Q type and are aligned during manufacture so as to track the frequency of the corresponding local oscillator 215, 216 and 217 so as to remove as much unwanted signal as possible and to pass the selected channel to the corresponding mixer. Each of the mixers converts the desired or selected channel to an intermediate frequency (IF) which is typically between 32 and 40MHz or between 40 and 48MHz. The mixer outputs are connected to a variable gain IF amplifier 218, whose output is connected to the input of a further amplifier 219 which provides suitable matching to an IF filter 220 of bandpass type. The filter 220 has a passband, which may be suitably shaped according to the modulation standard of the received signal, which passes the selected channel and substantially rejects all other channels. The output of the filter is connected to a further variable gain amplifier 221 which provides impedance matching and gain to compensate for the insertion loss of the filter 220.

The output of the amplifier 221 is typically supplied to a block 222 containing an equaliser, a COFDM demodulator, a forward error corrector (FEC), an automatic gain control (AGC) circuit and an analog-digital converter (ADC). The AGC control circuit supplies control signals to the variable gain amplifiers 218 and 221 to control the gains thereof in the conventional way for providing automatic gain control. An MPEG 2 decoder 224 may also be provided. The output of the amplifier 221 may alternatively or additionally be supplied to an analog baseband demodulator 223.

Figure 2 illustrates the degree of integration which is conventionally achieved in terrestrial television tuners. In particular, the tuner shown in Figure 2 comprises six separate integrated circuits and a large number of external components. The integrated circuits comprise: the synthesiser 201; the mixers 225, 226 and 227 and the local oscillators 215, 216 and 217; the amplifiers 218, 219 and 221; the circuit block 222; the demodulator 223; and the decoder 224. This architecture requires a relatively large number of external components and involves using similar circuit architecture and component selection for the tracking filters 209, 210 and 211 and the local oscillators 212-217. Also, careful alignment of the various tracking tuned circuits is required during manufacture in order to ensure acceptable performance. This architecture is more selective in the radio frequency section and reduces or rejects large unwanted channels before they can interfere with wanted channels because of non-linearities in the subsequent mixers and amplifiers which produce cross-modulation and intermodulation. The tracking filters are also solely responsible for rejecting the image channel. This architecture may be implemented using amplifiers and mixers of modest signal handling capabilities with low noise figures and moderate power consumption.

Figure 4 of the accompanying drawings illustrates a typical dual conversion cable tuner of conventional type. A broadband signal containing, for example, about 100 channels is supplied by a cable distribution network to an antennae input 400 and is supplied to a fixed filter 401 (shown in more detail in Figure 5 of the accompany drawings) which attenuates signals outside the band containing the channels. The filtered signal is supplied to a controllable attenuator 402 forming part of an automatic gain control arrangement. The output of the attenuator 402 is supplied to a first frequency changer comprising a mixer 403, a local oscillator 404 and a phase locked loop synthesiser 410 provided with a crystal controlled reference oscillator 409. The first frequency changer performs frequency up-conversion to a first intermediate frequency typically between 1.1 GHz and 1.3GHz.

The output of the mixer 403 is supplied to a fixed bandpass filter 404 whose centre frequency is at the first intermediate frequency and which has a passband which passes the selected channel at the first intermediate frequency and several adjacent channels.

In the architecture illustrated, the filter 404 is connected to an amplifier 405 whose output is connected via a further filter 406 to a second frequency changer.

The second frequency changer also comprises a mixer 407, a local oscillator 408 and a phase locked loop synthesiser 411. The second frequency changer performs frequency down-conversion and converts the frequency of the selected channel to the second intermediate frequency, which is generally between 30 and 50MHz. The output of the mixer 407 is supplied to a variable gain amplifier 412 forming part of the AGC arrangement of the tuner. The output of the amplifier 412 is supplied to a buffer 413 providing impedance matching to a second intermediate frequency bandpass filter 414, whose centre frequency is at the second intermediate frequency and whose passband is such that it passes the selected channel, possibly with some passband shaping, and substantially rejects all other channels in the signal from the second frequency changer. The output of the filter 415 is supplied to the input of another variable gain amplifier 415 forming part of the AGC circuit of the tuner. The output of the amplifier 415 is supplied to a circuit block 416, 417 of the same type as that shown at 222 in Figure 2 of the accompanying drawings and provided with an MPEG 2 decoder 419 and/or to an analog baseband demodulator 418.

The architecture illustrated in Figure 4 of the accompanying drawings places the image channel at the first frequency changer outside the input band by using a first intermediate frequency which is higher than the highest frequency of the input band. For first intermediate frequencies between 1.1 and 1.3GHz, the image channels are between 2 and 4GHz depending on which channel is currently selected. All of the signal-handling stages ahead of the first IF filter 404 are required to handle as many as 100 channels simultaneously and must therefore have high signal handling capabilities.

There are generally between 4000 and 9000 interfering third order intermodulation product combinations, of the forms F1 + F2 + F3, F1 + F2 ― F3 and F1 ― F2 ― F3 where F1, F2 and F3 represent the frequencies of three unwanted channels, that fall on any selected channel. There are likewise many second order intermodulation products of the form F1 + F2 and F1 ― F2 which may also cause interference. Thus, the active stages such as the mixer and a tracking low noise amplifier (when present) ahead of the first IF filter 404 must be of very high linearity in order to achieve acceptable levels of composite third order intermodulation and composite second order intermodulation interference. All generated intermodulation products are evenly weighted by the relatively constant signal level across the full input band. This architecture requires fewer passive components than the single conversion architecture but requires the use of higher power stages to achieve the necessary very high signal handling.

Figure 4 again illustrates the level of integration which has typically been achieved in tuners of this architecture. Thus, such a tuner typically comprises seven integrated circuits comprising: the first frequency changer 403, 404; the second frequency changer 407, 408; the synthesisers 410 and 411 and the oscillator 409; the amplifiers 412, 413 and 415; the block 416, 417; the demodulator 418; and the decoder 419.

The increasing range of multi-media services available through modern digital television formats and the need to be able simultaneously to demodulate more than one channel have resulted in a need to reduce the cost and size of television tuners. The need to be able to receive and demodulate analog channels in the presence of digital channels and vice versa has resulted in the need for increased tuner performance for both cable and terrestrial television. Demodulation of digital channels is more sensitive to tuner phase noise performance but more tolerant of co-channel and intermodulation interference than demodulation of analog channels.

The desire for reduced cost and size has lead to various attempts to increase the level of integration of television tuners, in particular to the point where almost the whole tuner can be embodied in a monolithic integrated circuit. Examples of this are disclosed in US 5 737 035 and US 6 177 964. Each of these documents discloses a highly integrated tuner of the dual conversion type and proposes various techniques for making a single integrated circuit tuner a viable option. However, such highly integrated arrangements generally either consume too much power to be acceptable or fail to meet at least one of the critical performance parameters, such as insufficient phase noise performance for digitally modulated signals, insufficient noise and intermodulation performance for terrestrial reception, or insufficient blocking of non-terrestrial channels.

Further examples of known radio frequency tuners are disclosed in GB 2 313 008, GB 2 067 865, GB 2 058 500, US 5 200 826, US 4 581 643, US 553 264, US 6 177 964, US 6 118 499, US 5 204 972, US 4 491 976 and GB 2 298 750. Examples of phase locked loop frequency synthesisers are disclosed in US 4 491 976, WO 00/69074, WO 99/31807, WO 91.07824, US 5 055 802 and IEEE Journal of Solid-State Circuits, Vol. 28, No. 5, May 1993 (USA), T.A.D Riley et al, "Delta-sigma modulation in fractional-N frequency synthesis", pages 553-559.

US 6 118 499 and GB 2 298 750 disclose timers for television and mobile radio signals, respectively, having automatic gain control arrangements which measure the signal level downstream of single channel filtering. The tuner gain is therefore controlled on the basis of the signal level of the channel selected for reception and is not substantially influenced by the level of signals outside the selected channel.

According to a first aspect of the invention, there is provided a television tuner as defined in the appended claim 1.

According to a second aspect of the invention, there is provided a television tuner as defined in the appended claim 14.

Preferred embodiments of the invention are defined in the other appended claims.

It is thus possible to provide a television tuner which meets or exceeds all of the performance requirements for digital and analog modulated signals for cable and terrestrial television standards throughout the world. Such a tuner may be very highly integrated with a requirement for very few external components and occupying a small area of a circuit board. The power consumption of such an integrated circuit tuner can be made very low, for example less than one watt.

Such a tuner may be implemented using BiCMOS or CMOS processes using bulk silicon or silicon-on-insulator (SOI) substrates. For example, the tuner may be implemented as deep sub-micron CMOS on bulk silicon.

The invention will be further described, by way of example, with reference to the accompanying drawings, in which:
Figure 1 is a diagram illustrating cable and terrestrial television frequency allocation and examples of signal levels in cable and terrestrial television channels;
Figure 2 is a block diagram of a known type of terrestrial television tuner;
Figure 3 is a circuit diagram of tracking filters used in the tuner of Figure 2;
Figure 4 is a block diagram of a known type of cable television tuner for a set top box;
Figure 5 is a circuit diagram of a band limiting filter of the tuner of Figure 4;
Figure 6 is a block diagram of a television tuner constituting a preferred embodiment of the invention; and
Figures 7 and 8 are graphs of amplitude against frequency illustrating the generation of spurious products in an oscillator controlled by a phase locked loop.

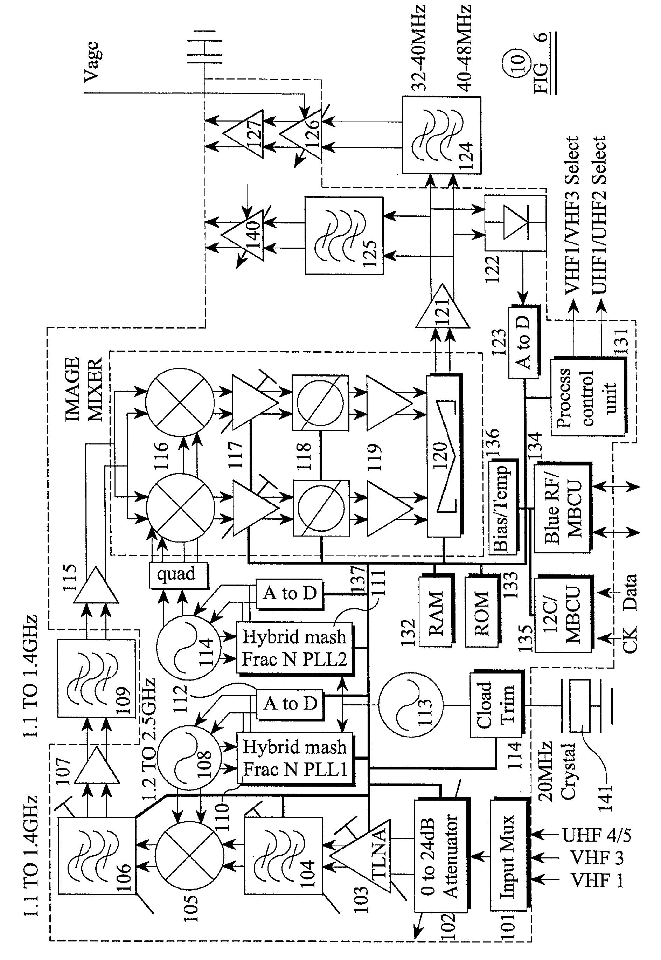

The tuner 10 shown in Figure 6 can be used for receiving television or other multi-media signals using any analog or digital modulation format from any source, including a terrestrial aerial and a cable distribution network. The tuner comprises three inputs for receiving different parts of the whole reception band, for example, via external filtering. In the case of terrestrial television signals as illustrated in Figure 6, the inputs are for the VHF1 band, the VHF3 band and the UHF4/5 band. For cable applications, a single input receiving the whole of the broadband cable signal may be used.

The three inputs are connected to an input multiplexer 101 which allows the appropriate input to be selected. The output of the multiplexer 101 is connected to a variable attenuator 102, for example comprising a stepped attenuator arranged to provide attentuation between 0 and 24dB in a plurality of discrete steps. The attenuator 102 is connected to an on-chip control bus 137 for controlling the attenuation provided by the attenuator 102.

The output of the attenuator 102 is connected to the input of a tracking low noise amplifier (TLNA) 103 having a highly linear transfer function and the ability to handle high signal levels with very low distortion levels. The TLNA also incorporates filtering, for example in its output stage, which is controllable via the bus 137. The output of the amplifier 103 is connected to a tracking bandpass filter 104 which receives control signals from the bus 137. The filter 104 and the filtering in the TLNA 103 are controlled so as to pass at least the channel selected for reception and some of the adjacent channels while attenuating the other channels in the broadband signal at the input of the amplifier 103. The filter 104 may be of active or passive type and is integrated onto the substrate of the monolithic integrated circuit. The presence of the filtering reduces the level of unwanted signals and allows a relatively large overall composite signal handling performance to be achieved without requiring external filtering components.

The filter 104 and the filtering in the TLNA 103 may be in the form of step tracking filtering, continuously tuned filtering, or a combination of the two. In the case of step tracking filtering, for example, the filtering may comprise a plurality of sections having overlapping bandpass characteristics with the appropriate section being selected in accordance with the frequency of the selected channel. In the case of continuously tuned filtering, a single filter section having a bandpass response may be tunable over the whole frequency range of the broadband input signal. Alternatively, several sections covering different ranges and with overlapping between the ranges may each be continuously tuned and the appropriate section may be selected in accordance with the selected channel.

The output of the filter 104 is supplied to a first frequency changer comprising an image reject mixer 105, a local oscillator 108, a "hybrid" mash sigma-delta fractional N phase locked loop synthesiser 110 and an analog/digital converter (ADC) 112. The first frequency changer performs frequency up-conversion such that a selected channel is converted to a first fixed intermediate frequency. The phase locked loop synthesiser 110 is controlled via the bus 137 so as to tune the oscillator 108 such that the selected channel is converted to any desired intermediate frequency in the range 1.1 to 1.4GHz, where all standard first intermediate frequencies used throughout the world are located. The ADC 112 converts the control voltage, supplied by the synthesiser 110 to the local oscillator 108, to the corresponding digital code and supplies this to the bus 137.

The use of an image reject mixer as the first mixer 105 provides an improvement in performance of the tuner. Noise and any signal present in the image channel would otherwise be present in the output of the mixer and this would degrade the noise performance of the tuner. Also, the increased undesirable energy at the output of the mixer 105 would have a detrimental effect on the dynamic range of one or more of the subsequent stages. These disadvantages are overcome by the use of the image reject mixer.

The output of the mixer 105 is supplied to a first intermediate frequency filter 106 formed on the substrate. The filter 106 is of the bandpass type and has an adjustable centre frequence controlled via the bus 137 so as to be alignable to any desired standard (or other) first intermediate frequency. The filter 106 generally has a passband sufficiently wide to pass the desired channel at the first intermediate frequency and several adjacent channels such as two to four channels either side of the selected channel, while attenuating or rejecting all other channels in the output signal from the mixer 105.

The output of the filter 106 is supplied to the input of an amplifier 107 having a very high dynamic range and a good noise performance. The output of the amplifier 107 is available as a connection of the integrated circuit for an external component and may be connected, as shown, to another first intermediate frequency filter 109 located off the integrated circuit. For example, the filter 109 may be embodied by ceramic-coupled resonators or surface acoustic wave (SAW) devices and is of the bandpass type with a centre frequency between 1.1 and 1.4GHz. The filter 109 may be of the type which passes the selected channel and a few adjacent channels and attenuates or rejects all of the other channels present in the output signal from the amplifier 107, for example by providing a relative attenuation of such channels of 40dB. Alternatively, the filter 109 may be a single channel filter such that it passes only the selected channel at the first intermediate frequency and substantially rejects all other channels.

The output of the filter 109 is connected to another connection of the integrated circuit which in turn is connected to the input of a buffer stage or amplifier 115. The output and input characteristics, such as impedances, and the gains of the amplifiers 107 and 115 are arranged to be suitable for properly matching the requirements of standard filters for use as the filter 109 and for making up the insertion loss of the filter. In embodiments where less filtering at the first intermediate frequency is acceptable, the filter 109 may be omitted and the output of the amplifier 107 connected to the input of the stage 115 so that first intermediate frequency filtering is performed by the on-chip filter 106.

The output of the stage 115 is connected to a second image reject mixer which includes a local oscillator 114, a "hybrid" mash sigma-delta fractional N phase locked loop synthesiser 111 and an ADC. The local oscillator 114 supplies in-phase and quadrature local oscillator signals via a quadrature circuit QUAD to I and Q mixers 116. The outputs of the mixers 116 are connected to the inputs of adjustable I and Q gain stages 117, whose gains are controllable via the bus 137. The outputs of the stages 117 are connected to a pair of programmable intermediate frequency all-pass Hilbert phase shift filters 118, whose outputs are connected via respective amplifier stages 119 to a summer 120. The characteristics of the filters 118 and the relative weightings of the I and Q signals applied in the summer 120 are adjustable or programmable via the bus 137.

The synthesiser 111 is not a fixed frequency reference; instead, it is controlled via the bus 137 and allows any desired second intermediate frequency to be selected between, for example, 30 and 50MHz. In particular, in European television standards, the second intermediate frequency is generally between 32.25 and 39.25MHz whereas the corresponding US standard generally puts the second intermediate frequency between 42.55 and 48.25MHz. by suitably programming the synthesiser 111, any second intermediate frequency within a relatively large range can be set according to the application of the tuner.

The output of the second image reject mixer is connected to the input of an amplifier or buffer stage 121 which provides output characteristics suitable for driving one or more second intermediate frequency filters. The outputs of the stage 121 are connected to an on-chip second intermediate frequency filter 125 and to substrate connections for an external second intermediate frequency filter 124. The on-chip filter 125 has fixed characteristics whereas the off-chip filter 124 may be selected in accordance with the requirements of the particular application of the tuner. Each of these filters is of bandpass type with a centre frequency at the desired second intermediate frequency and a passband which passes the selected channel, possibly with frequency shaping appropriate to the modulation standard of the received signal, and substantially rejects all other channels in the output signal of the second frequency changer. The output of the on-chip filter 125 is connected via a variable gain amplifier 140 to an output connection of the integrated circuit for connection to one or more demodulators in accordance with the application. The internal or on-chip filter 125 is sufficient for many applications, such as a cable tuner where channel filtering may be completed in the digital domain following conversion of the output signal from the tuner in an analog-digital converter, for example within a demodulator integrated circuit. For more demanding applications such as terrestrial television, the external or off-chip filter 124 may be used so as to provide higher selectivity and higher signal handling. The integrated circuit has an input for connection to the output of the filter 124 and this input is connected via a variable gain amplifier 126 and an output buffer 127 to a further output of the tuner. As shown in Figure 6, the variable gain amplifier 126 is connected to receive an external voltage Vagc forming part of an automatic gain control arrangement, for example controlled by a demodulator to which the tuner output is connected. The gain of the amplifier 140 may be controlled in the same way.

The output of the stage 121 is connected to a detector 122 for detecting the signal amplitude or level and for providing automatic gain control. The level detected by the detector 122 is supplied to a digital-to-analog converter 123, which supplies the corresponding digital code to the bus 137 so as to control the attenuation of the attentuator 102. However, the digital code is available, and the control input of the attenuator 102 is accessible, via the bus 137 to permit more sophisticated automatic gain control (AGC) strategies to be used if necessary or desirable.

The synthesisers 110 and 111 are provided with a common frequency reference in the form of a crystal-controlled oscillator 113 connected to an off-chip 20MHz crystal 141. The crystal is provided with an on-chip capacative load trimming arrangement 114 controlled via the bus 137. In particular, the capacative loading can be programmed so as to trim or align the frequency of the oscillator 113.

The integrated circuit has formed thereon a temperature sensor 136, which monitors the substrate temperature and also gives an indication of the temperature of adjacent components, such as the external filter 109. A process control unit 131 performs various control operations including providing compensation for any change with temperature of the centre frequency of the filter 109. In particular, the unit 131 contains a look-up table comprising a compensation function for adjusting the synthesisers 110 and 111 to compensate for any change in the centre frequency of the filter 109.

The integrated circuit includes a random access memory (RAM) 133 and a read only memory (ROM) 134 connected to the bus 137. The RAM 132 contains alignment factors which are loaded on power-up of the tuner and which set up the tuner for optimal alignment for a particular tuner application. The ROM 133 contains, among other things, synthesiser programming data for the different television channels around the world. This reduces the burden on a base processor, which only needs to communicate a channel number rather than the full register contents to the synthesisers 110 and 111.

The integrated circuit also comprises standard interface arrangements 134 and 135 allowing the tuner to be controlled by conventional interconnections, such as I2C. Three Wire and Bluetooth. In particular, the interfaces 134 and 135 provide serial to parallel interfacing between the parallel bus 137 and external serial buses.

As described hereinbefore, the first intermediate frequency filter 109 may be of the type which passes only the selected channel or of the type which passes the selected channel and several adjacent channels. In embodiments of the tuner where the filter 109 passes several channels, the signal level monitored by the detector 122 is upstream or ahead of the single channel filtering performed by the filter 125, by the filter 124 (when present), and by any filtering in a demodulator to which the tuner is connected. The amplitude detected by the detector 122 therefore provides a better representation of the signal level present at the inputs of the various stages of the tuner and, particularly, the signal level at the input of the amplifier 103. The detector 122 is thus able to control the attenuation provided by the attenuator 102 so as to ensure that an appropriate signal level is present at the input of the amplifier 103. However, the various stages between the input and the detector 122 provide gains which vary as a result of manufacturing tolerances. The gains of various amplifier stages are therefore made programmable so that the gain structure of the tuner can be aligned according to the desired application. For example, the gains of the amplifiers 117 are programmable via the bus 137 and can be programmed in accordance with the desired gain structure during an alignment step forming part of the manufacturing process of the tuner. The signal level detected by the detector 122 then bears a well-defined relationship to the signal levels at the inputs of the various stages and the appropriate AGC control strategy can be adopted. For example, the attack and decay characteristics and the loop time constants of the AGC arrangement are programmable and can be selected in accordance with the tuner application.

The detector 122 may control other variable gain stages, such as the variable gain amplifiers 126 and 140. In general, "direct" control of the attenuator 102 is performed by the AGC control strategy whereas other stages are subjected to "delay" control. In other words, for increasing input signal levels, the detector 122 initially controls the attenuator 102 so as to reduce the signal level at the input of the amplifier 103 without controlling the gain of other stages. For signal levels higher than a predetermined threshold, which may or may not correspond to maximum attenuation provided by the attenuator 102, the detector 122 may then reduce the gain of other stages. The specific control strategy depends on the tuner application, for example whether digital or analog channels are to be received and whether the tuner is for terrestrial or cable systems, and can be programmed into the integrated circuit or selected from a plurality of strategies stored in the integrated circuit. For example, the AGC control loop may be arranged to limit the magnitude of the (multi-channel) signal present at the input of the second intermediate frequency filter 124 or 125 to a programmed level which represents the known maximum level that can be handled by the previous stages for the type of modulation of the selected channel.

In the case of a tuner for receiving terrestrial signals and having a first intermediate frequency filter 109 which passes more than one channel, the signals present at various of the tuner stages may have a range of amplitudes as illustrated in Figure 1. Thus, a channel may be selected for reception but one or more of the stages of the tuner may receive that channel together with adjacent or near channels of much higher amplitude. Providing automatic gain control on the basis of the signal level in the selected channel, for example by controlling this on the basis of the demodulated channel signal, could result in a gain structure such that undesirably high signal levels were present at various stages in the tuner. The performance of the tuner could therefore be very substantially degraded, for example with respect to cross-modulation and intermodulation. By basing the automatic gain control on the total signal energy in several channels including the selected one, the automatic gain control strategy can provide a more appropriate gain structure within the tuner so as to avoid undesirably high generation of cross-modulation and intermodulation products. This results in improved reception because interference with the selected channel can be substantially reduced, even in the presence of adjacent and near channel signals of much higher amplitude.

Both of the local oscillator arrangements 108, 110, 111 and 114 of the first and second frequency changers comprise fully integrated tuned oscillators with no external components being required. The first oscillator 108, 110 is a stepped broadband oscillator capable of covering the tuning range from 1.1 to 2.2GHz. The second oscillator 111, 114 has a narrower tuning range and is a quadrature oscillator providing two local oscillator signals in phase quadrature with respective to each other. The tuning range of this oscillator is required to be sufficiently wide to cover the ranges of first and second intermediate frequencies in use around the world.

A critical performance requirement of each of the oscillators is the amount of jitter which can be tolerated without impairing the subsequent demodulation process. The required performance depends on the class of modulation. For example, conventional analog vestigial sideband amplitude modulation can tolerate higher levels of jitter than digital modulation schemes such as 256 QAM used in digital cable networks. In fact, at present, the most onerous requirement is for 256 QAM (quadrature amplitude modulation) because a large portion of the signal information is carried in the phase of the carrier and any jitter in the frequency changer oscillators is added to the wanted signal in the mixer stages.

In order to remove excess jitter from the oscillator signals supplied to the mixers 105 and 116, the phase locked loops 110 and 111 have a relatively broad loop bandwidth. However, a disadvantage of conventional broad loop bandwidth phase locked loops is the need for a higher reference comparison frequency in the phase detector of the loop. This results in coarser tuning steps in such a conventional phase locked loop. In particular, if the reference frequency is 1MHz, the controlled reference is a multiple of 1MHz so that the smallest incremental step size in tuning is also 1MHz. Although this may, for some applications, be acceptable for the first frequency changer, such incremental steps are too coarse for the second frequency changer. Also, a 1MHz reference signal requires a multiple of 2000 when tuning the first oscillator 108 to 2GHz. This multiplication factor limits the phase noise of the controlled reference within the phase locked loop bandwidth to 66dB greater than the phase noise of the crystal-controlled oscillator 113, whose performance is typically no better than -150dB. The resulting phase noise within the phase locked loop bandwidth is limited to -150 + 66 = -84dBC/Hz, which is barely adequate for proper reception of 256 QAM signals.

The synthesisers 110 and 111 thus employ fractional N techniques in order to provide sufficiently fine incremental tuning steps using a high frequency comparison reference in the form of a 20MHz crystal 141. In particular, the synthesisers 110 and 111 are sigma delta hybrid mash fractional N synthesisers.

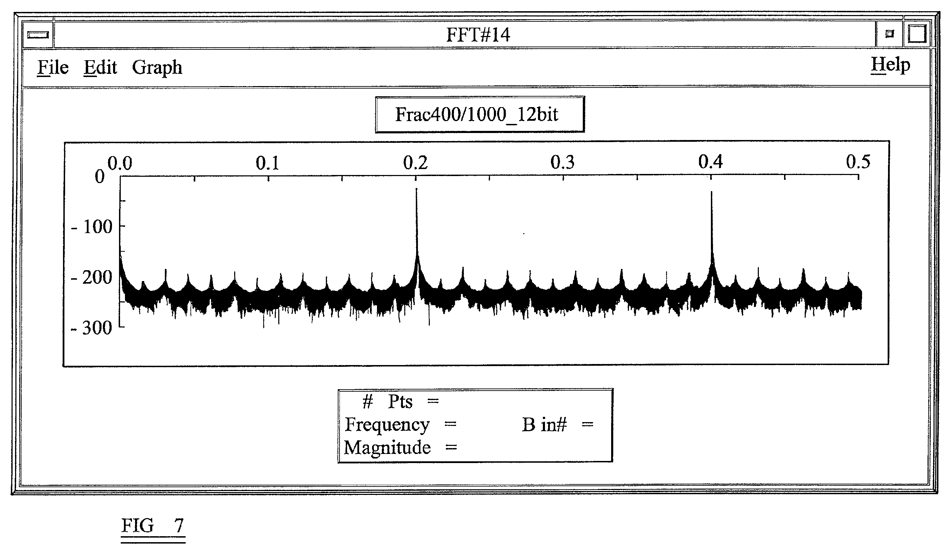

A disadvantage of conventional fractional N synthesisers is the increased spurious signal generation at the fractional comparison frequency. Sigma delta fractional N synthesisers use a sigma delta modulator to generate a dithered fraction pattern having a dc component equal to the required tuning fraction but with high order sigma delta modulator noise shaping to the fraction. However, when simple fractions are used, such as a half, a quarter or several eighths, the error spectrum associated with the fractional dither pattern is concentrated into a few relatively strong spurious signals, for example as illustrated in Figure 7 for a fraction of four tenths.

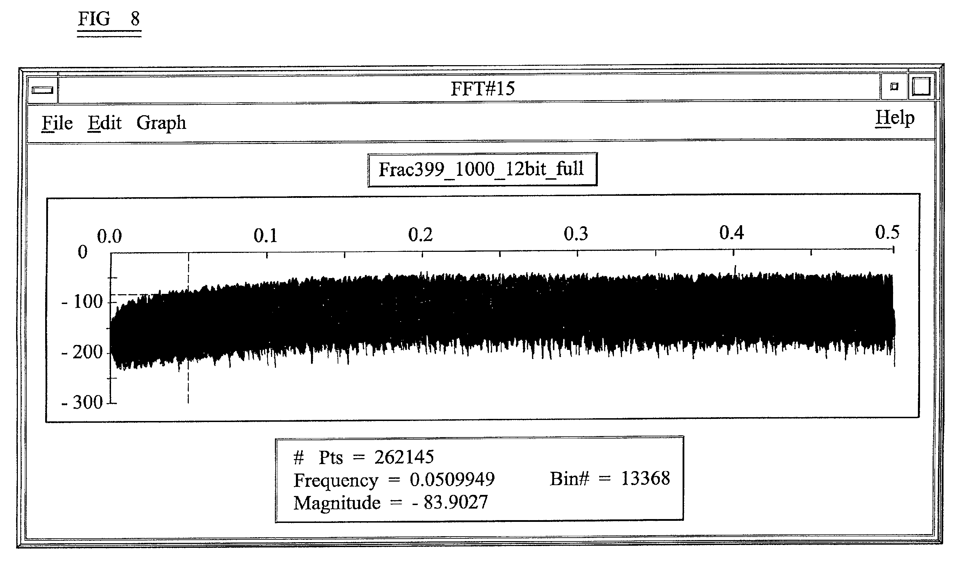

For less simple fractions such as 399 thousandths the spurious energy is more evenly spread across the frequency band as illustrated in Figure 8 and is more easy to manage. In particular, the possibility of the spurious signals reacting with a large unwanted channel at an offset frequency from the wanted channel similar to the offset of the spurious signal from the local oscillator can be greatly reduced. The difference between a fraction of four tenths and a fraction of 399 thousandths represents a fine tuning step of 20KHz when a 20MHz comparison reference is used and such a small offset from the desired first or second intermediate frequency has no substantial effect on the performance of the tuner. The synthesisers 110 and 111 may therefore easily be controlled by a suitable control strategy for avoiding simple fractions so as to provide improved performance. Simple fractions can be avoided by using fine tuning of both synthesisers to select the wanted channels and avoiding simple fractions by incrementing the tuning of one of the oscillators by a small step and applying the inverse increment to the other oscillator.

As described hereinbefore, in one embodiment of the tuner, the filter 109 is arranged to pass a single channel and substantially to reject all other channels. However, the centre frequency of such a filter is subject to manufacturing tolerances and varies with the temperature of the filter. In order to compensate for this, the frequency changers are required to have fine incremental tuning steps and this may be provided as described hereinbefore. The synthesisers 110 and 111 can be programmed during tuner manufacture so as to ensure that the selected channel following conversion by the first frequency changer is centred on the actual passband of the filter 109 and likewise the selected channel converted by the second frequency changer is centred on the passband of the second intermediate frequency filtering. By physically arranging the integrated circuit and the filter 109 so that the temperature sensor 136 provides a reasonably good indication of the filter temperature, the variation of centre frequency of the filter 109 with temperature can be compensated by adjusting the synthesisers 110 and 111 in accordance with the appropriate compensation function. For example, the variation of centre frequency with temperature may be a reasonably accurately known function supplied by the filter manufacturer and the compensation function may be stored as a look-up table within the integrated circuit. Alternatively, one or more typical samples of the filter 109 may be tested to determine the relationship between centre frequency and temperature and the resulting function or averaged function may be used to generate the compensation function.

It is thus possible to provide a highly integrated monolithic television tuner requiring very few external components and capable of providing acceptable performance with a wide range of types of input signals. The tuner can be programmed for optimum performance with any type of television signal from any source and is capable of complying with the television standards, such as intermediate frequencies, channel spacing and carrier frequency allocations, in use around the world. The very high level of integration results in reduced cost of manufacture and reduced circuit board area requirement so that the tuner is commercially acceptable even for highly cost-sensitive applications.

## Claims

1. A television tuner comprising:
a radio frequency input for receiving a broadband input signal containing a plurality of channels;
a first frequency changer (105, 108, 110) for converting any selected one of the channels to be within a first frequency band containing a first intermediate frequency;
a second frequency changer (111, 114, 116-120) for converting the selected channel from the first frequency changer (108, 110) to be within a second frequency band containing a second intermediate frequency;
single channel filtering (124, 125) for passing the selected channel and for substantially rejecting all of the other channels; and
a controllable attenuator (102) between the input and the first frequency changer (105, 108, 110), **characterised by** an automatic gain controller (122) for controlling the attenuator (102) in response to the amplitude of a signal upstream of the single channel filtering (124, 125).

2. A tuner as claimed in claim 1, **characterised in that** the first and second frequency changers (105, 108, 110, 111, 114,116-120), the attenuator (102) and the controller (122) are physically located on a single integrated circuit substrate.

3. A tuner as claimed in claim 1 or 1, **characterised in that** the upstream signal is an input signal to the single channel filtering (124, 125).

4. A tuner as claimed in any one of the preceding claims **characterised in that** the attenuator (102) is a stepped attenuator.

5. A tuner as claimed in any one of the preceding claims, **characterised by** a first intermediate frequency filter (106, 109) between the first and second frequency changers (105, 108, 110, 111, 114, 116-120) for passing the selected channel from the first frequency changer (105, 108, 110) and at least one further channel adjacent thereto, the upstream signal being downstream of the first intermediate frequency filter (106, 109).

6. A tuner as claimed in claim 5, **characterised in that** the upstream signal is downstream of the second frequency changer (111, 114, 116-120).

7. A tuner as claimed in claim 5 or 6, **characterised by** a second intermediate frequency filter (124, 125) downstream of the second frequency changer (111, 114, 116-120).

8. A tuner as claimed in claim 7, **characterised in that** the second intermediate frequency filter (124, 125) has a frequency response for passing the selected channel from the second frequency changer (111, 114, 116-120) and for substantially rejecting all other channels converted by the second frequency changer (111, 114, 116-120).

9. A tuner as claimed in any one of the preceding claims, **characterised by** a variable gain amplifier downstream of the second frequency changer (111, 114, 116-120).

10. A tuner as claimed in claim 9 when dependent on claim 2, **characterised in that** the variable gain amplifier is physically located on the substrate.

11. A tuner as claimed in any one of the preceding claims, **characterised by** at least one stage having adjustable gain between the attenuator (102) and the single channel filtering (124, 125).

12. A tuner as claimed in claim 11 when dependent on claim 2 or 10, **characterised in that** the at least one stage is physically located on the substrate.

13. A tuner as claimed in claim 11 or 12, **characterised in that** the adjustable gain is programmable.

14. A television tuner comprising:
a radio frequency input for receiving a broadband input signal containing a plurality of channels;
a first frequency changer (105, 108, 110) for converting any selected one of the channels to be within a first frequency band containing a first intermediate frequency and comprising a mixer (105), a local oscillator (108), and phase locked loop synthesiser (110); and
a second frequency changer (111, 114, 116-120) for converting the selected channel from the first frequency changer (105, 108, 110) to be within a second frequency band containing a second intermediate frequency,
**characterised in that** the synthesiser (110) is a hybrid mash sigma delta fractional N phase locked loop synthesiser.

15. A tuner as claimed in claim 14, **characterised in that** the first and second frequency changers (105, 108, 110, 111, 114, 116-120) are physically located on a single integrated circuit substrate.

16. A tuner as claimed in claim 14 or 15, **characterised in that** the second frequency changer comprises a mixer (116-120), a local oscillator (114), and a hybrid mash sigma-delta fractional N phase locked loop synthesiser (111).

17. A tuner as claimed in any one of claims 1 to 13, **characterised in that** the first frequency changer comprises a mixer (105), a local oscillator (108) and a hybrid mash sigma-delta fractional N phase locked loop synthesiser (110).

18. A tuner as claimed in any one of the preceding claims, **characterised by** a tracking radio frequency filter (104) between the input and the first frequency changer (105, 108, 110) for passing at least the selected channel in the broadband input signal.

19. A tuner as claimed in claim 18, **characterised in that** the tracking filter (104) is a bandpass filter.

20. A tuner as claimed in claim 18 or 19, **characterised in that** the tracking filter (104) is a stepped tracking filter.

21. A tuner as claimed in any one of claims 18 to 20, **characterised by** a tracking low noise amplifier (103) between the input and the tracking filter (104).

22. A tuner as claimed in claim 21, **characterised in that** the low noise amplifier (103) is a tracking tuned low noise amplifier.

23. A tuner as claimed in any one of the preceding claims, **characterised in that** the first frequency changer (105, 108, 110) is an up-converter and the second frequency changer (111, 114, 116-120) is a down-converter.

24. A tuner as claimed in claim 23, **characterised in that** the first frequency changer (105, 108, 110) is arranged to convert the plurality of channels in the broadband signal to a frequency range which is higher than the highest frequency of the broadband signal.

25. A tuner as claimed in any one of the preceding claims, **characterised in that** the second frequency changer (111, 114, 116-120) comprises an image reject mixer (116-120).

26. A tuner as claimed in any one of the preceding claims, **characterised by** a plurality of radio frequency inputs and a multiplexer (101) for connecting any selected one of the inputs for supplying a signal to the first frequency changer (105, 108, 110).

27. A tuner as claimed in any one of the preceding claims, **characterised in that** the first frequency changer (105, 108, 110) comprises an image reject mixer (105).
